# EUROPEAN PATENT APPLICATION

(11) **EP 3 683 335 A1**
(43) Date of publication of application: **22.07.2020**
(21) Application number: 18857143.4
(22) Date of filing: 07.09.2018
(51) Int. Cl.: C23F 1/30, B23K 1/00, C23F 1/18, H05K 3/06

(54) **ETCHING LIQUID FOR ACTIVE METAL BRAZING MATERIALS AND METHOD FOR PRODUCING CERAMIC CIRCUIT BOARD USING SAME**

(30) Priority: 12.09.2017 JP 2017174788; 25.01.2018 JP 2018010680
(71) Applicant: Kabushiki Kaisha Toshiba, Minato-ku Tokyo 105-0023 (JP); Toshiba Materials Co., Ltd., Yokohama-shi, Kanagawa 235-0032 (JP)
(72) Inventor: KATO, Hiromasa, Yokohama-shi Kanagawa 235-0032 (JP); HIRABAYASHI, Hideaki, Yokohama-shi Kanagawa 235-0032 (JP); KAWASHIMA, Fumiyuki, Yokohama-shi Kanagawa 235-0032 (JP); SASAKI, Akito, Yokohama-shi Kanagawa 2350032 (JP)
(74) Representative: Henkel & Partner mbB
(86) International application number: PCT/JP2018/033197
(87) International publication number: WO 2019/054291

(57) **Abstract**

An etching liquid for active metal brazing materials, which is used for the purpose of etching an active metal brazing material layer that contains Ag, Cu and an active metal. This etching liquid for active metal brazing materials contains ammonium fluoride, hydrofluoboric acid, and one or two substances selected from among hydrogen peroxide and ammonium peroxodisulfate.

## Description

### [Technical Field]

An embodiment relates to a reactive metal brazing material etchant and a method for manufacturing a ceramic circuit board using the same.

### [Background Art]

The outputs of power modules are being increased. Accordingly, guaranteed operating temperatures of semiconductor elements have become high and are 175 °C or more. Therefore, it is desirable also to improve the TCT (thermal cycle test) characteristics of ceramic circuit boards on which the semiconductor elements are mounted.

For example, the provision of an oblique structure in a copper plate side surface and the optimization of the jutting portion size of a bonding layer are recited in International Publication No. 2017/056360 (Patent Literature 1). Excellent TCT characteristics are obtained in Patent Literature 1. It is particularly favorable to optimize the jutting portion size of the bonding layer.

Etching of a brazing material layer is performed to control the jutting portion size of the bonding layer. A reactive metal brazing material is used to bond the ceramic substrate and the copper plate. The reactive metal brazing material is a brazing material including Ag (silver), Cu (copper), and Ti (titanium). Also, Sn (tin) and/or In (indium) are included as necessary. The reactive metal brazing material includes components other than Cu. Therefore, the brazing material layer remains after the process of etching the copper plate itself into a prescribed pattern shape. Therefore, a brazing material etching process that removes the unnecessary brazing material layer is necessary.

For example, a brazing material etchant in which a chelating agent, hydrogen peroxide, and a pH-adjusting agent are mixed is used in Japanese Patent No. 4811756 (Patent Literature 2). In Patent Literature 2, Ethyleneiaminetetraacetic acid (EDTA) or the like is used as the chelating agent. Also, aqueous ammonia is used as the pH-adjusting agent. In Patent Literature 2, the brazing material jutting portion size is controlled by such brazing material etching.

However, in the method of Patent Literature 2, a long period of time of 150 minutes is necessary for one brazing material etching process. Therefore, the suitability for mass production is poor.

### [Citation List]

### [Patent Literature]

[Patent Literature 1] International Publication No. 2017/056360
[Patent Literature 2] Japanese Patent No. 4811756

### [Summary of Invention]

### [Problem to be Solved by the Invention]

A problem to be solved by an aspect of the invention is to provide a reactive metal brazing material etchant having excellent suitability for mass production, and a method for manufacturing a ceramic circuit board using the reactive metal brazing material etchant.

### [Means for Solving the Problem]

In a reactive metal brazing material etchant for etching a reactive metal brazing material layer including Ag, Cu, and a reactive metal, the reactive metal brazing material etchant includes ammonium fluoride, fluoroboric acid, and one type or two types selected from hydrogen peroxide and ammonium peroxodisulfate.

### [Brief Description of Drawings]

[FIG. 1]

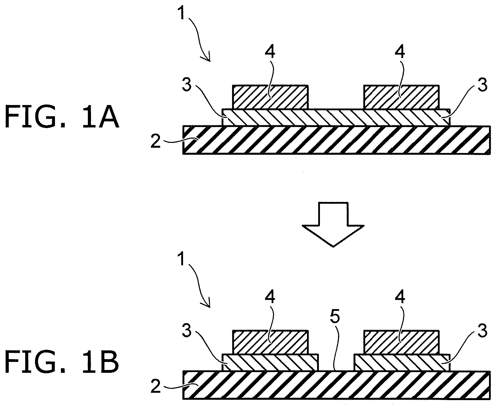

   FIG. 1 is a drawing illustrating a method for manufacturing a ceramic circuit board.
[FIG. 2]

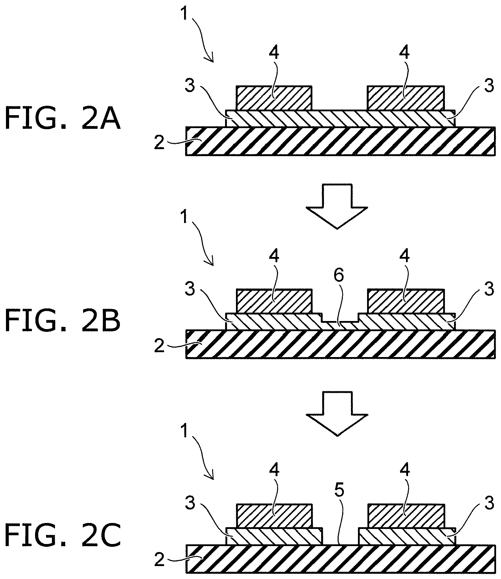

   FIG. 2 is a drawing illustrating another method for manufacturing a ceramic circuit board.

### [Modes for Carrying Out the Invention]

A reactive metal brazing material etchant according to an embodiment is a reactive metal brazing material etchant for etching a reactive metal brazing material layer including Ag, Cu, and a reactive metal, in which the reactive metal brazing material etchant includes ammonium fluoride, fluoroboric acid, and one type or two types selected from hydrogen peroxide and ammonium peroxodisulfate.

The reactive metal brazing material etchant includes ammonium fluoride, fluoroboric acid, and one type or two types selected from hydrogen peroxide and ammonium peroxodisulfate. Also, it is favorable for the fluoroboric acid to be HBF₄.

The ceramic circuit board will now be described.

A method for manufacturing the ceramic circuit board is illustrated in FIG. 1A and FIG. 1B. In FIG. 1A and FIG. 1B, 1 is the ceramic circuit board; 2 is a ceramic substrate; 3 is a reactive metal brazing material layer; 4 is a copper member; and 5 is a brazing material removal region. Also, FIG. 1A illustrates the ceramic circuit board before etching the reactive metal brazing material layer 3. FIG. 1B illustrates the ceramic circuit board after etching the brazing material layer.

In the ceramic circuit board 1, the copper member 4 is bonded to at least one surface of the ceramic substrate 2 via the reactive metal brazing material layer 3. Although the copper member is bonded to only one surface in FIG. 1, copper members may be bonded to two surfaces. Also, the front surface-side copper member is used as the circuit pattern. Also, the back surface-side copper member may be a heat dissipation plate (without a pattern shape) or may be used as a circuit pattern.

The ceramic substrate 2 is a silicon nitride substrate, an aluminum nitride substrate, an aluminum oxide substrate, an Alusil substrate, etc. Also, the plate thickness of the ceramic substrate is, for example, 0.2 to 0.8 mm. For example, the thermal conductivity of the silicon nitride substrate is 80 W/m·K or more; and the three-point bending strength of the silicon nitride substrate is 600 MPa or more. For example, the thermal conductivity of the aluminum nitride substrate is 150 W/m·Kor more; and the three-point bending strength of the aluminum nitride substrate is 300 to 550 MPa. For example, the aluminum oxide substrate has a thermal conductivity of 20 to 40 W/m·K and a three-point bending strength of 400 to 500 MPa. Also, the Alusil substrate is an aluminum oxide substrate including zirconium oxide. For example, the thermal conductivity of the Alusil substrate is 20 to 40 W/m·K; and the three-point bending strength of the Alusil substrate is 450 to 600 MPa. Because the strength of the silicon nitride substrate is high, it is possible to thin the substrate to be 0.33 mm or less. The aluminum nitride substrate has a high thermal conductivity. Also, although the thermal conductivities of the aluminum oxide substrate and the Alusil substrate are low, these substrates are inexpensive. The type of the ceramic substrate can be selected as appropriate to match the purpose. Also, the silicon nitride substrate and the aluminum nitride substrate are called nitride ceramics. The aluminum oxide substrate and the Alusil substrate are called oxide ceramics.

It is favorable for the copper member to be made of oxygen-free copper. When the oxygen inside the copper member is high, there is a possibility that the bonding strength may decrease in the reactive metal bonding. The copper member may be a copper plate or may be a film of copper formed on a brazing material layer. Hereinafter, the case will be described where the copper member is a copper plate.

It is favorable for the plate thickness of the copper plate to be 0.2 mm or more. Also, the heat dissipation of the copper plate can be improved by increasing the thickness to be 0.7 mm or more. Although the upper limit of the plate thickness is not particularly limited, it is favorable for the plate thickness of the copper plate to be 5 mm or less. When the plate thickness exceeds 5 mm, the warp of the ceramic circuit board becomes large when bonding the copper plate and the ceramic substrate. Also, the patterning into the pattern shape by etching becomes difficult.

The reactive metal brazing material includes Ag, Cu, and a reactive metal as essential components. The combination of Ag and Cu is eutectic. By forming the AgCu eutectic, the bonding strength between the ceramic substrate and the copper plate can be increased. Also, the reactive metal is one, two, or more types selected from Ti (titanium), Zr (zirconium), Hf (hafnium), and Nb (niobium). Among the reactive metals, Ti is favorable. The reactive metal can form a strong bond by reacting with the ceramic substrate. A reactive metal nitride phase is formed with the nitride ceramic. For example, a titanium nitride (TiN) phase is formed in the case where the reactive metal includes Ti. Also, a reactive metal oxide phase is formed with the oxide ceramic. For example, a titanium oxide (TiO₂) phase is formed in the case where the reactive metal includes Ti. Also, the reactive metal may be a simple metal or may be added as a hydride.

Also, Sn (tin) or In (indium) may be added to the reactive metal brazing material as necessary. Sn and In can lower the melting point of the reactive metal brazing material. Therefore, the bonding temperature can be lowered. Bonding at a low temperature can reduce the residual stress of the bonded bodies. The decrease of the residual stress is effective to increase the thermal cycle reliability of the bonded bodies.

Also, C (carbon) may be added to the reactive metal brazing material as necessary. The fluidic property of the brazing material can be suppressed by adding carbon. Therefore, the thickness of the brazing material layer can be more uniform.

Also, in the reactive metal brazing material, it is favorable for the content of Ag to be not less than 40 wt% and not more than 80 wt%, the content of Cu to be not less than 15 wt% and not more than 45 wt%, the content of the reactive metal to be not less than 1 wt% and not more than 12 wt%, the content of Sn (or In) to be not less than 0 wt% and not more than 20 wt%, and the content of C to be not less than 0 wt% and not more than 2 wt%. The total content of Ag, Cu, Ti, Sn (or In), and C is taken as 100 wt%. Also, when Sn or In is added to the reactive metal brazing material, it is favorable for the content of Sn or In to be 5 wt% or more. In the case where both Sn and In are added, it is favorable for the total content to be within the range of 5 to 20 wt%. Also, when carbon is added to the reactive metal brazing material, it is favorable for the content of carbon to be 0.1 wt% or more.

The bonding process includes mainly a coating process and a heating process.

In the coating process, first, the bonding brazing material paste recited above is prepared. The bonding brazing material paste is coated onto the ceramic substrate; and the copper plate is placed on the bonding brazing material paste. It is favorable for the coating thickness of the bonding brazing material paste to be within the range of 10 to 60 µm. For a coating thickness of less than 10 µm, there is a risk that the bonding strength may decrease due to insufficient bonding brazing material. Also, when the coating thickness exceeds 60 µm, improvement of the bonding strength is not observed; and this also causes a cost increase. In the case where the copper plate is bonded to two surfaces, the bonding brazing material paste is coated onto the two surfaces of the ceramic substrate. Also, it is favorable to place a copper plate having about the same size as the region where the brazing material paste is coated. Also, a copper plate that is pre-patterned into a pattern shape may be placed on the ceramic substrate.

Then, a heating process is performed. The heating temperature is within the range of 700 to 900 °C. Also, it is favorable for the heating process to be performed in a non-oxidative atmosphere in an atmosphere of 1x10⁻³ Pa or less. The bonding temperature can be set to 850 °C or less by adding Sn or In to the brazing material.

The ceramic substrate and the copper plate can be bonded by such processes.

To form a location where the reactive metal brazing material layer is exposed, it is effective to etch the copper plate 4. An etching resist for forming the pattern shape is coated onto the copper plate 4. Subsequently, a process of etching the copper plate is performed using the etching resist as a mask.

A method of bonding a copper plate that is pre-patterned into a pattern shape also is effective. On the other hand, considering the misalignment of the copper plate in the bonding process, it may be difficult to accommodate a complex pattern shape and/or a fine pitch (narrow spacing between adjacent copper plates). Therefore, it is favorable to pattern the copper plate into the pattern shape by etching. A fine pitch refers to the spacing between the adjacent copper plates being 2 mm or less.

Iron chloride mainly is used in the copper plate etching process. Iron chloride is effective for etching copper. On the other hand, a brazing material layer that includes Ag, Cu, and a reactive metal cannot be etched by iron chloride. Therefore, a location exists where the brazing material layer is exposed. Also, a cleaning process may be performed after the copper plate etching process as necessary. Instead of iron chloride, copper chloride may be used to etch the copper plate.

The exposed reactive metal brazing material layer 3 is etched.

Hydrogen peroxide (H₂O₂) and ammonium peroxodisulfate ((NH₄)₂S₂O₈) have the effect of removing Ag and Cu. These etching components can remove Ag and Cu by ionization. In particular, the effect of the ionization is increased by setting the pH to be 6 or less. Hydrogen peroxide and ammonium peroxodisulfate also have the effect of an oxidizing agent that oxidizes one, two, or more types selected from a reactive metal, Sn, In, and carbon. For example, in the case where the brazing material includes Ti, TiN (titanium nitride) is on the nitride ceramic substrate. The etching components described above have the effect of changing Ti or TiN into TiO₂. Similarly, there is an effect of changing the Sn inside the brazing material layer 3 into SnO₂. This is similar for In as well.

Ammonium fluoride (NH₄F) functions as an etchant of oxides. For example, TiO₂ can be changed into TiOF₂ and removed. Also, ammonium hydrogen fluoride ((NH₄)HF₂) also is included in ammonium fluoride.

Fluoroboric acid can stabilize the pH of the etchant. Specifically, the pH of the reactive metal brazing material etchant can be 6 or less. Also, as described below, the pH of the etchant can be not less than 4 and not more than 6 by controlling the mixing ratio of fluoroboric acid, ammonium fluoride, and hydrogen peroxide or ammonium peroxodisulfate.

Also, the pH of the etchant can be not less than 4.8 and not more than 5.8 by using HBF₄. Also, HBF₄ functions as an etchant etching the brazing material layer. Therefore, the rate of etching the reactive metal brazing material layer can be faster.

Also, the pH of the etchant can be lowered to be not less than 4.0 and not more than 4.8 by adding the chelating agent described below. The etching rate can be faster by lowering the pH of the etchant.

It is favorable for the pH of the etchant including ammonium fluoride, fluoroboric acid, and one type or two types selected from hydrogen peroxide and ammonium peroxodisulfate to be not less than 4.8 and not more than 5.8. Further, it is favorable for the pH of the etchant to which the chelating agent is added to be not less than 4.0 and not more than 4.8.

It is favorable for the hydrogen peroxide to have the quality of JIS-K-1463 (2007). ISO 6352-2 is referred to in JIS-K-1463. Also, it is favorable for the ammonium peroxodisulfate to have the quality of JIS-K-8252 (2010).

The rate of etching the brazing material layer is slower when the pH of the brazing material etchant is greater than 6. Also, when the pH is less than 4, there is a possibility that the rate of etching the brazing material layer undesirably may be too fast. To improve the TCT characteristics of the ceramic circuit board, it is necessary to cause the brazing material jutting portion (the bonding layer jutting portion) to remain. When the etching rate of the brazing material layer is too fast, the control of the size of the brazing material jutting portion is difficult. Therefore, it is favorable for the pH of the etchant to be not less than 4 and not more than 6, and more favorable to be not less than 4.0 and not more than 5.8.

When the total of the weight of hydrogen peroxide, ammonium fluoride, and fluoroboric acid is taken as 100 wt%, it is favorable for the content of hydrogen peroxide to be not less than 30 wt% and not more than 86 wt%. Also, it is favorable for the content of ammonium fluoride to be not less than 9 wt% and not more than 40 wt%. Also, it is favorable for the content of fluoroboric acid to be not less than 5 wt% and not more than 50 wt%. The roles of the components can be leveraged in these ranges. Also, the oxidation-reduction potential (ORP) when etching the brazing material can be high. From this perspective as well, the rate at which the brazing material etching is performed can be faster.

It is favorable for hydrogen peroxide, ammonium fluoride, and fluoroboric acid each to be mixed as aqueous solutions. It is favorable to use a hydrogen peroxide-including aqueous solution in which the content of hydrogen peroxide is 15 to 70 wt%. It is favorable to use an ammonium fluoride-including aqueous solution in which the content of ammonium fluoride is 15 to 60 wt%. It is favorable to use a fluoroboric acid-including aqueous solution in which the content of fluoroboric acid is 15 to 60 wt%.

Also, a brazing material etchant is prepared by mixing the hydrogen peroxide-including aqueous solution, the ammonium fluoride-including aqueous solution, and the fluoroboric acid-including aqueous solution. The brazing material etchant may be diluted by mixing water. 0.5 to 2 L of water may be mixed when the total of the hydrogen peroxide-including aqueous solution, the ammonium fluoride-including aqueous solution, and the fluoroboric acid-including aqueous solution is 1 L (liter). Also, it is favorable for the mixing to be uniform by stirring sufficiently. It is favorable for the water to satisfy the quality of JIS-K-0557 (1998). The quality of A1 to A4 is shown in JIS-K-0557. ISO 3696 is referred to in JIS-K-0557.

Also, when the total of the weights of the ammonium peroxodisulfate, the ammonium fluoride, and the fluoroboric acid is taken as 100 wt%, it is favorable for the content of ammonium peroxodisulfate to be within the range not less than 23 wt% and not more than 95 wt%, for the content of ammonium fluoride to be within the range not less than 3 wt% and not more than 50 wt%, and for the content of fluoroboric acid to be within the range not less than 2 wt% and not more than 55 wt%. The roles of the components can be leveraged in these ranges. Also, the oxidation-reduction potential (ORP) can be high when etching the brazing material. From this perspective as well, the rate at which the brazing material etching is performed can be faster.

Also, it is favorable for the ammonium peroxodisulfate, the ammonium fluoride, and the fluoroboric acid each to be mixed as aqueous solutions. An ammonium peroxodisulfate-including aqueous solution in which the content of ammonium peroxodisulfate is 15 to 70 wt% is favorable. An ammonium fluoride-including aqueous solution in which the content of ammonium fluoride is 15 to 60 wt% is favorable. A fluoroboric acid-including aqueous solution in which the content of fluoroboric acid is 15 to 60 wt% is favorable.

Also, a brazing material etchant is prepared by mixing the ammonium peroxodisulfate-including aqueous solution, the ammonium fluoride-including aqueous solution, and the fluoroboric acid-including aqueous solution. The brazing material etchant may be diluted by mixing water. 0.5 to 2 L of water may be mixed when the total of the ammonium peroxodisulfate-including aqueous solution, the ammonium fluoride-including aqueous solution, and the fluoroboric acid-including aqueous solution is 1 L (liter). Also, it is favorable for the mixing to be uniform by stirring sufficiently. Also, it is favorable for the water to satisfy the quality of JIS-K-0557 (1998). The quality of A1 to A4 is shown in JIS-K-0557.

Also, in the case where both hydrogen peroxide and ammonium peroxodisulfate are used, when the total of the weights of hydrogen peroxide, ammonium peroxodisulfate, ammonium fluoride, and fluoroboric acid is taken as 100 wt%, it is favorable for the total content of hydrogen peroxide and ammonium peroxodisulfate to be within the range not less than 35 wt% and not more than 96 wt%, for the content of ammonium fluoride to be within the range not less than 2 wt% and not more than 50 wt%, and for the content of fluoroboric acid to be within the range not less than 2 wt% and not more than 50 wt%. Also, similarly, mixing as aqueous solutions is favorable.

Also, the brazing material etchant may include a chelating agent. When the total of the weights of ammonium fluoride, fluoroboric acid, a chelating agent, and one type or two types selected from hydrogen peroxide and ammonium peroxodisulfate is taken as 100 wt%, it is favorable for the content of the chelating agent to be within the range not less than 0.01 wt% and not more than 5 wt%. Also, it is favorable for the chelating agent to be one, two, or more types selected from glycine, CDTA, dicarboxylic acid, tricarboxylic acid, and oxycarboxylic acid.

The chelating agent has an effect of suppressing the precipitation of Cu. The reactive metal brazing material layer includes Cu (copper). As the etching of the reactive metal brazing material layer progresses, Cu ions in the etchant increase. Saturation occurs when the Cu ions exceed a constant amount; and if the Cu undesirably precipitates, the etching rate decreases. By adding the chelating agent, the re-precipitation of the Cu that has become ions can be prevented. The decrease of the etching rate of the reactive metal brazing material layer can be prevented thereby. Also, when the chelating agent is included, the pH of the etchant can be lowered.

It is favorable for the chelating agent to be one, two, or more types selected from glycine, CDTA, dicarboxylic acid, tricarboxylic acid, and oxycarboxylic acid. These chelating agents easily form Cu ions and complex ions.

When the total of the weights of ammonium fluoride, fluoroboric acid, a chelating agent, and one type or two types selected from hydrogen peroxide and ammonium peroxodisulfate is taken as 100 wt%, it is favorable for the content of the chelating agent to be within the range not less than 0.01 wt% and not more than 5 wt%. The effect of the addition is insufficient when the content is less than 0.01 wt%. Also, there is a possibility that the etching rate conversely may decrease when the content exceeds 5 wt% and the added amount is too high. Therefore, it is favorable for the content of the chelating agent to be not less than 0.01 wt% and not more than 5 wt%, and more favorable to be not less than 0.1 wt% and not more than 3 wt%.

Glycine refers to aminoacetic acid or a salt of aminoacetic acid. CDTA is cyclohexanediaminetetraacetate. CDTA also is notated as CyDTA. Also, dicarboxylic acid refers to having two carboxyl groups in the molecular formula. Also, oxycarboxylic acid refers to having a hydroxide group and a carboxyl group in the molecular formula. Dicarboxylates also are included in dicarboxylic acid. Also, tricarboxylates are included in tricarboxylic acid. Also, oxycarboxylates are included in oxycarboxylic acid.

The etching time can be shortened by etching the brazing material layer by using such a brazing material etchant. If the thickness of the brazing material layer is 60 µm or less, the etching can be performed in 30 minutes or less.

The etchant that includes hydrogen peroxide, ammonium peroxodisulfate, ammonium fluoride, and fluoroboric acid can etch only the reactive metal brazing material layer without etching the copper plate. Therefore, the reactive metal brazing material layer also can be etched after removing the etching resist used when etching-patterning the copper plate.

By etching the brazing material layer after removing the etching resist for etching the copper plate, the reaction of the etching resist and the reactive metal brazing material etchant can be prevented. Therefore, the pH of the reactive metal brazing material etchant can be maintained for a long period of time to be not less than 4 and not more than 6, and more favorably not less than 4.0 and not more than 5.8. Because the pH can be maintained in this range for a longer period of time, the processed number of ceramic circuit boards can be increased. The processed number can be increased even without replenishing the reactive metal brazing material etchant. The etching process of the reactive metal brazing material layer may be performed while causing the etching resist for etching the copper plate to remain.

It is also effective to heat the brazing material etchant. The etching reaction can be stimulated by heating the temperature of the brazing material etchant to 30 to 70 °C.

It is favorable for the brazing material etching process to be performed while applying an ultrasonic wave to the ceramic circuit board via the brazing material etchant. By performing the brazing material etching process while applying the ultrasonic wave, the brazing material etching time can be shortened further. Also, it is favorable for the frequency of the ultrasonic wave to be not less than 10 kHz and not more than 100 kHz. When the frequency is less than 10 kHz, the effect of applying the ultrasonic wave is small. Also, more effects are not obtained by increasing beyond 100 kHz. Also, the burden of the apparatus increases. Therefore, it is favorable for the frequency of the ultrasonic wave to be 10 to 100 kHz, and more favorable to be 20 to 70 kHz.

By etching the brazing material while applying the ultrasonic wave, the time of one brazing material etching process can be 20 minutes or less. Although the lower limit of the time of the brazing material etching process is not particularly limited, it is favorable for the lower limit to be 1 minute or more. When less than 1 minute, there is a possibility of the removal effect of the brazing material layer and the oxidation effect of the brazing material layer being insufficient.

The etching of the reactive metal brazing material layer may be divided into two or more processes. In such a case, the components of the brazing material etchant used in the brazing material etching process of the second time may be different from the components of the brazing material etchant used in the brazing material etching process of the first time. Also, a cleaning process that uses purified water may be performed between the processes as necessary.

The etching performance degrades as the process of etching the reactive metal brazing material layer by using the brazing material etchant according to the embodiment is repeated. The major cause of the degradation is the decrease of the concentration of the hydrogen peroxide or the ammonium peroxodisulfate. As described above, these components function as an ionization or oxidizing agent of the reactive metal brazing material layer components. The etching of the reactive metal brazing material layer is started by this function. Therefore, the consumption proceeds from the hydrogen peroxide or the ammonium peroxodisulfate. The etching performance of the reactive metal brazing material layer etchant according to the embodiment can be maintained by replenishing the decrease amount when the concentration of hydrogen peroxide decreases. Similarly, when the concentration of ammonium peroxodisulfate decreases, the etching performance can be maintained by replenishing the decrease amount. The criterion of the concentration decrease is a decrease of 10 to 20 wt% from the initial concentration. When the concentration decrease is less than 10 wt%, the decrease of the etching performance is low. On the other hand, when the concentration decrease exceeds 20 wt%, the decrease of the etching performance before replenishing becomes large. Therefore, it is favorable to replenish the hydrogen peroxide of the reactive metal brazing material etchant when the concentration of hydrogen peroxide has decreased 10 to 20 wt% from the initial concentration. Similarly, it is favorable to replenish the ammonium peroxodisulfate of the reactive metal brazing material etchant when the concentration of ammonium peroxodisulfate has decreased 10 to 20 wt% from the initial concentration. Also, the change amount of the pH of the etchant increases as the concentration of hydrogen peroxide or ammonium peroxodisulfate decreases.

By using the reactive metal brazing material etchant according to the embodiment as shown in FIG. 1A and FIG. 1B, the brazing material removal region 5 is formed by etching the location where the brazing material layer 3 is exposed between the copper plates 4. By using the reactive metal brazing material etchant according to the embodiment, the brazing material layer 3 can be etched in a shorter amount of time; and the size of the portion of the brazing material layer 3 jutting from between the ceramic substrate 2 and the copper plate 4 can be controlled.

Another method for manufacturing a ceramic circuit board is illustrated in FIG. 2A to FIG. 2C. FIG. 2A to FIG. 2C shows an example in which the process of etching the brazing material layer 3 is performed multiple times. First, as shown in FIG. 2A and FIG. 2B, the location where the brazing material layer 3 is exposed between the copper plates 4 is etched. Thereby, the thickness at the location is reduced; and a brazing material residual region 6 is formed. Subsequently, the brazing material removal region 5 is formed by removing the brazing material residual region 6 by further etching in another etching process.

The components of the etchant used in the etching of the first time may be the same as or different from the components of the etchant used in the etching of the second time. A cleaning process, etc., may be performed between the etching process of the first time and the etching process of the second time.

### (Examples)

### (Examples 1 to 16 and comparative example 1)

A silicon nitride substrate (having a substrate thickness of 0.32 mm, a thermal conductivity of 90 W/m·K, and a three-point bending strength of 650 MPa), an aluminum nitride substrate (having a substrate thickness of 0.635 mm, a thermal conductivity of 180 W/m·K, and a three-point bending strength of 350 MPa), an aluminum oxide substrate (having a substrate thickness of 0.635 mm, a thermal conductivity of 20 W/m·K, and a three-point bending strength of 450 MPa), and an Alusil substrate (having a substrate thickness of 0.635 mm, a thermal conductivity of 20 W/m·K, and a three-point bending strength of 500 MPa) were prepared as ceramic substrates. The sizes of the ceramic substrates were unified to be length 50 mmxwidth 40 mm.

For the copper plates, the two types of a copper plate having a thickness of 0.5 mm and a copper plate having a thickness of 0.8 mm were prepared. The copper plate that had the thickness of 0.5 mm was taken as the "copper plate 1"; and the copper plate that had the thickness of 0.8 mm was taken as the "copper plate 2". Also, the sizes of the copper plates were unified to be length 46 mmxwidth 36 mm.

The bonding brazing materials shown in Table 1 were prepared.

**[Table 1]**

| | brazing material composition |
|---|---|
| brazing material 1 | Ag(55.5)-Cu(26)-Sn(10)-Ti(8)-C(0.5) |
| brazing material 2 | Ag(59)-Cu(25)-Sn(13)-Ti(3) |
| brazing material 3 | Ag(68)-Cu(30)-Ti(2) |

The reactive metal bonding process was performed by combining the ceramic substrate, the brazing material, and the copper plate as in Table 2. A brazing material layer that matched the copper plate size was coated; and the copper plate was placed.

The reactive metal bonding process was performed in a non-oxidative atmosphere at 1x10⁻³ Pa or less. Also, the bonding was performed at 780 to 850 °C when using the brazing material 1 and the brazing material 2. Also, the bonding was performed at 860 to 880 °C when using the brazing material 3. Also, the copper plates were bonded to two surfaces of the ceramic substrate.

The ceramic circuit boards according to the samples 1 to 6 were prepared by these processes.

**[Table 2]**

| ceramic circuit board | ceramic substrate | brazing material | brazing material layer thickness (µm) | copper plate |
|---|---|---|---|---|
| sample 1 | silicon nitride substrate | brazing material 1 | 20 | copper plate 2 |
| sample 2 | silicon nitride substrate | brazing material 2 | 35 | copper plate 2 |
| sample 3 | silicon nitride substrate | brazing material 2 | 15 | copper plate 1 |
| sample 4 | silicon nitride substrate | brazing material 2 | 25 | copper plate 1 |
| sample 5 | aluminum nitride substrate | brazing material 2 | 20 | copper plate 1 |
| sample 6 | aluminum nitride substrate | brazing material 3 | 20 | copper plate 1 |
| sample 7 | Alusil substrate | brazing material 3 | 20 | copper plate 1 |

For the ceramic circuit boards according to the samples 1 to 6, after coating an etching resist on the copper plate on the front surface side, a pattern shape was patterned by etching-patterning. A location where the pattern-pattern distance was 1.5 mm and a location where the pattern-pattern distance was 2.0 mm were provided in the copper plate pattern. By performing copper plate etching-patterning, ceramic circuit boards in which the brazing material layers are exposed were prepared.

Then, the brazing material etchants shown in Table 3 were prepared. The mass ratios of the brazing material etchant that are shown are when the total of hydrogen peroxide (H₂O₂), ammonium fluoride (NH₄F), and fluoroboric acid (HBF₄) is taken as 100 wt%. Aqueous solutions were mixed to provide the mass ratios shown in Table 3. Also, the purified water amounts (L: liters) that were mixed with a total of 1 L of a hydrogen peroxide (H₂O₂)-including aqueous solution, an ammonium fluoride (NH₄F)-including aqueous solution, and a fluoroboric acid (HBF₄)-including aqueous solution are shown. Also, the pH is shown for the brazing material etchants.

Also, as a comparative example, EDTA was used instead of HBF₄ in the brazing material etchant 5.

**[Table 3]**

| | brazing material etchant | | | | |
|---|---|---|---|---|---|
| | H₂O₂ (wt%) | NH₄F (wt%) | HBF₄ (wt%) | purified water(L) | pH |
| brazing material etchant 1 | 30 | 25 | 45 | 1.0 | 5.3 |
| brazing material etchant 2 | 35 | 35 | 30 | 0.8 | 5.6 |
| brazing material etchant 3 | 50 | 20 | 30 | 1.5 | 5.1 |
| brazing material etchant 4 | 65 | 20 | 15 | 1.0 | 4.9 |
| brazing material etchant 5 (comparative Example) | 30 | 34 | EDTA 36 wt% | 1.0 | 5.5 |

Also, an etchant that uses ammonium peroxodisulfate is shown in Table 4. The mass ratios are shown for when the total of ammonium peroxodisulfate ((NH₄)₂S₂O₈), ammonium fluoride (NH₄F), and fluoroboric acid (HBF₄) is taken as 100 wt%. Aqueous solutions were mixed to provide the mass ratios shown in Table 4. Also, the purified water amounts (L: liters) that were mixed with a total of 1 L of an ammonium peroxodisulfate ((NH₄)₂S₂O₈)-including aqueous solution, an ammonium fluoride (NH₄F)-including aqueous solution, and a fluoroboric acid (HBF₄)-including aqueous solution are shown. Also, the pH is shown for the brazing material etchants.

**[Table 4]**

| | brazing material etchant | | | | |
|---|---|---|---|---|---|
| | (NH₄)₂S₂O₈ (wt%) | NH₄F (wt%) | HBF₄ (wt%) | purified water (L) | pH |
| brazing material etchant 6 | 25 | 45 | 30 | 1.2 | 5.5 |
| brazing material etchant 7 | 40 | 35 | 25 | 0.7 | 5.3 |
| brazing material etchant 8 | 70 | 15 | 15 | 1.4 | 5.0 |

Then, a chelating agent was added to the brazing material etchants 1 to 4 and 6 to 8 to form the brazing material etchants 9 to 15. Similarly, the pH was measured. Also, the added amount of the chelating agent is shown as the proportion of the chelating agent when the total of the chelating agent, fluoroboric acid, ammonium fluoride, and one of hydrogen peroxide or ammonium peroxodisulfate is taken as 100 wt%. The results are shown in Table 5.

**[Table 5]**

| | brazing material etchant | | |
|---|---|---|---|
| | base | chelating agent (component · added amount wt%) | pH |
| brazing material etchant 9 | brazing material etchant 1 | glycine·1 wt% | 4.8 |
| brazing material etchant 10 | brazing material etchant 2 | CDTA·1 wt% | 4.7 |
| brazing material etchant 11 | brazing material etchant 3 | dicarboxylic acid·3 wt% | 4.0 |
| brazing material etchant 12 | brazing material etchant 4 | tricarboxylic acid·2 wt% | 4.3 |
| brazing material etchant 13 | brazing material etchant 5 | oxycarboxylic acid · 4 wt% | 4.2 |
| brazing material etchant 14 | brazing material etchant 6 | glycine·0.5 wt% | 4.5 |
| brazing material etchant 15 | brazing material etchant 7 | CDTA·1.5 wt% | 4.8 |

In the brazing material etchants 8 to 13, the chelating agent is added to a brazing material etchant which is the base. By adding the chelating agent, the pH of the etchant could be lowered.

The methods for manufacturing the ceramic circuit boards according to the examples 1 to 18 were performed for the ceramic circuit boards according to the samples 1 to 6 by using the brazing material etchants 1 to 15. Also, the brazing material etchant 5 was used in the comparative example 1.

14 L (liters) of each of the brazing material etchants were prepared. The brazing material etching-patterning was performed using forty ceramic circuit boards after etching the copper plates as one batch. Also, for the examples 1 to 9 and the comparative example 1, this was performed after removing the etching resist used when etching the copper plate. Also, for the examples 10 to 18, this was performed while the etching resist used when etching the copper plate remained. Also, the size of the ceramic circuit board was set to length 180 mmxwidth 140 mm. Also, the etching area per one ceramic circuit board was set to 200 mm².

Also, "ultrasonic wave" is displayed for the brazing material etching processes performed while applying an "ultrasonic wave". Also, the frequency of the ultrasonic wave was 50 kHz for the examples 1 to 12 and the comparative examples 1, and 70 kHz for the examples 13 to 21.

The change amounts of the pH of the brazing material etchants were measured after performing four batches (40 sheets×4 batches = 160 sheets processed). "ⓞ" is when the change amount of the pH is within the range of ±0.3, "○" when within the range of ±0.8, and "×" when the change amount is large and exceeds 1.0. The results are shown in Tables 6 and Table 7.

**[Table 6]**

| | ceramic circuit board | brazing material etching process | brazing material etchant pH change amount |
|---|---|---|---|
| example 1 | sample 1 | brazing material etchant 1 | ⊚ |
| | | ×10 minutes | |
| | | ×50°C; | |
| | | ultrasonic wave | |
| example 2 | sample 1 | brazing material etchant 1 | ⊚ |
| | | ×15 minutes | |
| | | ×40°C | |
| example 3 | sample 2 | brazing material etchant 1 | ○ |
| | | ×20 minutes | |
| | | ×35°C; | |
| | | ultrasonic wave | |
| example 4 | sample 3 | brazing material etchant 1 | ○ |
| | | ×23 minutes | |
| | | ×45°C; | |
| | | ultrasonic wave | |
| example 5 | sample 3 | brazing material etchant 2 | ⊚ |
| | | ×15 minutes | |
| | | ×50°C; | |
| | | ultrasonic wave | |
| example 6 | sample 4 | brazing material etchant 1 | ○ |
| | | ×18 minutes | |
| | | ×40°C; | |
| | | ultrasonic wave | |
| example 7 | sample 5 | brazing material etchant 3 | ○ |
| | | ×20 minutes | |
| | | ×60°C | |
| example 8 | sample 6 | brazing material etchant 2 | ○ |
| | | ×17 minutes | |
| | | ×50°C; | |
| | | ultrasonic wave | |
| example 9 | sample 2 | brazing material etchant 4 | ⊚ |
| | | ×15 minutes | |
| | | ×45°C; | |
| | | ultrasonic wave | |
| example 10 | sample 5 | brazing material etchant 6 | ○ |
| | | ×25 minutes | |
| | | ×50°C | |
| example 11 | sample 1 | brazing material etchant 7 | ○ |
| | | ×20 minutes | |
| | | ×40°C; | |
| | | ultrasonic wave | |
| example 12 | sample 3 | brazing material etchant 8 | ⊚ |
| | | ×16 minutes | |
| | | ×45°C; | |
| | | ultrasonic wave | |
| comparative example 1 | sample 4 | brazing material etchant 5 | x |
| | | ×20 minutes | |
| | | ×50°C; | |
| | | ultrasonic wave | |

**[Table 7]**

| | ceramic circuit board | brazing material etching process | brazing material etchant pH change amount |
|---|---|---|---|
| example 13 | sample 1 | brazing material etchant 9 | ⊚ |
| | | ×10 minutes | |
| | | ×50°C; | |
| | | ultrasonic wave | |
| example 14 | sample 1 | brazing material etchant 9 | ⊚ |
| | | ×15 minutes | |
| | | ×40°C | |
| example 15 | sample 2 | brazing material etchant 10 | ⊚ |
| | | ×20 minutes | |
| | | ×35°C; | |
| | | ultrasonic wave | |
| example 16 | sample 3 | brazing material etchant 11 | ⊚ |
| | | ×23 minutes | |
| | | ×45°C; | |
| | | ultrasonic wave | |
| example 17 | sample 3 | brazing material etchant 12 | ⊚ |
| | | ×20 minutes | |
| | | ×40°C | |
| example 18 | sample 3 | brazing material etchant 13 | ⊚ |
| | | ×15 minutes | |
| | | ×50°C; | |
| | | ultrasonic wave | |
| example 19 | sample 4 | brazing material etchant 14 | ⊚ |
| | | ×18 minutes | |
| | | ×40°C; | |
| | | ultrasonic wave | |
| example 20 | sample 5 | brazing material etchant 1 | ○ |
| | | ×15 minutes | |
| | | ×60°C | |
| example 21 | sample 6 | brazing material etchant 2 | ○ |
| | | ×20 minutes | |
| | | ×50°C; | |
| | | ultrasonic wave | |

It can be seen from the tables that the change amount of the pH was small for the brazing material etchants according to the examples. The replenish timing of the etchant can be postponed when the life of the brazing material etchant is long. Therefore, a brazing material etching process is possible in which the suitability for mass production is good and a cost reduction is possible. Also, the removal of the reactive metal brazing material layer was fast when the etching process was performed while applying the ultrasonic wave.

Also, the change amount of the pH was small for the brazing material etchants 9 to 15 (the examples 13 to 21) to which the chelating agent was added. Also, the pH change amount was slightly large when the chelating agent was not added such as in the example 15 and the example 16. As a result, it can be seen that for the brazing material etchants to which the chelating agent is added, the pH change amount was small even when the brazing material etching was performed with the etching resist still adhered to the copper plate. In other words, it can be said that the ease of use is good for the brazing material etchants to which the chelating agent is added because the pH change amount can be suppressed regardless of the existence or absence of the etching resist.

Conversely, the change amount of the pH was large for the comparative example. This makes it necessary to increase the frequency of the replenishment of the brazing material etchant.

Then, the brazing material etching processes according to the examples were repeated. The concentration of hydrogen peroxide or ammonium peroxodisulfate in the brazing material etchant was confirmed to have decreased 10 to 20 wt% from the initial concentration. Subsequently, after replenishing the decrease amount so that the concentration was the same as the initial concentration, similar brazing material etching processes were performed. The pH change amount of the brazing material etchant after replenishing was measured. The results are shown in Table 8.

**[Table 8]**

| | brazing material etchant pH change amount |
|---|---|
| example 1 | ⊚ |
| example 2 | ⊚ |
| example 3 | ○ |
| example 4 | ○ |
| example 5 | ⊚ |
| example 6 | ○ |
| example 7 | ○ |
| example 8 | ○ |
| example 9 | ⊚ |
| example 10 | ○ |
| example 11 | ○ |
| example 12 | ⊚ |
| example 13 | ⊚ |
| example 14 | ⊚ |
| example 15 | ⊚ |
| example 16 | ⊚ |
| example 17 | ⊚ |
| example 18 | ⊚ |
| example 19 | ⊚ |
| example 20 | ○ |
| example 21 | ○ |

It can be seen from the table that for the brazing material etchants according to the examples, equivalent brazing material etching performance was obtained by replenishing hydrogen peroxide or ammonium peroxodisulfate. Therefore, for the reactive metal brazing material etchant according to the embodiment, it was found that the etching performance can be maintained by replenishing the concentration of aqueous hydrogen peroxide or ammonium peroxodisulfate when the concentration has decreased 10 to 20 wt% from the initial concentration.

Although several embodiments of the invention are illustrated hereinabove, these embodiments are presented as examples and are not intended to limit the scope of the invention. These novel embodiments may be implemented in other various forms; and various omissions, substitutions, modifications, etc., can be performed without departing from the spirit of the invention. These embodiments and their modifications are within the scope and spirit of the invention and are within the scope of the invention described in the claims and their equivalents. Also, the embodiments described above can be performed in combination with each other.

## Claims

1. A reactive metal brazing material etchant for etching a reactive metal brazing material layer (3) including Ag, Cu, and a reactive metal,
the reactive metal brazing material etchant including ammonium fluoride, fluoroboric acid, and one type or two types selected from hydrogen peroxide and ammonium peroxodisulfate.

2. The reactive metal brazing material etchant according to claim 1, wherein the fluoroboric acid is HBF₄.

3. The reactive metal brazing material etchant according to any one of claim 1 to claim 2, wherein the reactive metal brazing material etchant includes one, two, or more types of chelating agents selected from glycine, CDTA, dicarboxylic acid, tricarboxylic acid, and oxycarboxylic acid.

4. The reactive metal brazing material etchant according to any one of claim 1 to claim 3, wherein when a total of ammonium fluoride, fluoroboric acid, a chelating agent, and one type or two types selected from hydrogen peroxide and ammonium peroxodisulfate is 100 wt%, a content of the chelating agent is not less than 0.01 wt% and not more than 5 wt%.

5. The reactive metal brazing material etchant according to any one of claim 1 to claim 4, wherein the reactive metal brazing material etchant is an aqueous solution.

6. The reactive metal brazing material etchant according to any one of claim 1 to claim 5, wherein a pH of the reactive metal brazing material etchant is 6 or less.

7. The reactive metal brazing material etchant according to any one of claim 1 to claim 6, wherein a pH of the reactive metal brazing material etchant is not less than 4.0 and not more than 5.8.

8. The reactive metal brazing material etchant according to any one of claim 1 to claim 7, wherein when a total of hydrogen peroxide, ammonium fluoride, and fluoroboric acid is 100 wt%, the hydrogen peroxide is within a range not less than 30 wt% and not more than 86 wt%, the ammonium fluoride is within a range not less than 9 wt% and not more than 40 wt%, and the fluoroboric acid is within a range not less than 5 wt% and not more than 50 wt%.

9. The reactive metal brazing material etchant according to any one of claim 1 to claim 7, wherein when a total of ammonium peroxodisulfate, ammonium fluoride, and fluoroboric acid is 100 wt%, the ammonium peroxodisulfate is not less than 23 wt% and not more than 95 wt%, the ammonium fluoride is not less than 3 wt% and not more than 50 wt%, and the fluoroboric acid is not less than 2 wt% and not more than 55 wt%.

10. The reactive metal brazing material etchant according to any one of claim 1 to claim 9, wherein the reactive metal brazing material layer (3) includes at least one type of Sn or In.

11. A method for manufacturing a ceramic circuit board (1), comprising etching a reactive metal brazing material layer (3) by using the reactive metal brazing material etchant according to any one of claim 1 to claim 10.

12. The method for manufacturing the ceramic circuit board (1) according to claim 11, wherein a thickness of the reactive metal brazing material layer (3) is not less than 10 µm and not more than 60 µm.

13. The method for manufacturing the ceramic circuit board (1) according to any one of claim 11 to claim 12, wherein the etching of the reactive metal brazing material layer (3) is performed while applying an ultrasonic wave.
